**Europäisches Patentamt**

**European Patent Office**

**Office européen des brevets**

(11) Veröffentlichungsnummer: **0 026 386**
**A2**

(12) # EUROPÄISCHE PATENTANMELDUNG

(21) Anmeldenummer: **80105491.7**

(22) Anmeldetag: **12.09.80**

(51) Int. Cl.³: **H 01 L 21/82**
**H 01 L 29/78, H 01 L 29/60**
**H 01 L 29/62**

(30) Priorität: **28.09.79 DE 2939488**

(43) Veröffentlichungstag der Anmeldung:
**08.04.81 Patentblatt 81/14**

(84) Benannte Vertragsstaaten:
**CH FR GB IT LI NL SE**

(71) Anmelder: **SIEMENS AKTIENGESELLSCHAFT Berlin und München**
**Postfach 22 02 61**
**D-8000 München 22(DE)**

(72) Erfinder: **Widmann, Dietrich, Dr. Ing.**
**Ludwig-Steub-Strasse 2**
**D-8025 Unterhaching(DE)**

(54) **Verfahren zur Herstellung von integrierten Halbleiterschaltungen, insbesondere CCD-Schaltungen, mit selbstjustierten, nichtüberlappenden Poly-Silizium-Elektroden.**

(57) Die Erfindung betrifft ein Verfahren zur Herstellung von integrierten Halbleiterschaltungen, insbesondere CCD-Schaltungen, mit selbstjustierten, nichtüberlappenden Poly-Silizium-Elektroden.

Bei bekannten Doppel-Silizium-Gate- Prozessen ($Si^2$-Gate-Prozessen) findet eine unvermeidliche Überlappung der Poly-Silizium-Elektroden der zweiten Poly-Silizium-Strukturebene mit den Poly-Silizium-Elektroden der ersten Poly-Silizium-Strukturebene statt.

Eine solche Überlappung ist wegen der erhöhten Koppel-kapazität und der begrenzten Packungsdichte unerwünscht.

Es besteht die Aufgabe, ein Herstellungsverfahren zu schaffen, durch das die Überlappungen vermeidbar sind.

Die Aufgabe wird wie folgt gelöst:

Bei der Ätzung der Poly-Si-1-Schicht werden im Bereich der aufzutragenden Poly-Si-2-Elektroden Höhlungen unter der Elektrodenisolierschicht $SiO_2$ oder $Si_3N_4$ zur Erzeugung von Überhängen erzeugt. Bei einer folgenden Gasphasenab-scheidung werden diese Höhlungen vollständig ausgefüllt. Nach dem Ätzen der Poly-Si-2-Schicht bleibt die entstandene Elektrodenkante außerhalb des Überlappungsbereiches.

FIG 4

0026386

SIEMENS AKTIENGESELLSCHAFT    Unser Zeichen
Berlin und München           VPA    79 P 7 1 8 4

Verfahren zur Herstellung von integrierten Halbleiterschaltungen, insbesondere CCD-Schaltungen, mit selbstjustierten, nichtüberlappenden Poly-Silizium-Elektroden

Die vorliegende Erfindung betrifft ein Verfahren zur
Herstellung von integrierten Halbleiterschaltungen,
insbesondere CCD-Schaltungen, mit selbstjustierten,
nichtüberlappenden Poly-Silizium-Elektroden.
Bei den bekannten Doppel-Silizium-Gate-Prozessen ($Si^2$-
Gate-Prozessen) findet in aller Regel eine nach dem
bekannten Herstellungsverfahren unvermeidliche Überlappung der Poly-Silizium-Elektroden der zweiten Poly-
Silizium-Strukturebene mit den Poly-Silizium-Elektroden der ersten Poly-Silizium-Strukturebene statt.

Eine solche Überlappung ist sowohl wegen der erhöhten
Koppelkapazität zwischen Poly-Si-1 und Poly-Si-2-Elektroden als auch wegen der begrenzten Packungsdichte der
Elektroden unerwünscht.

Aus "IEEE Journal of Solid-State Circuits, Vol. SC 11,
No. 1, February 1976" ist ein Prozeß zur Erzeugung
Pap 1 The / 26.9.1979

selbstjustierter, nichtüberlappender Aluminium-Elektroden mit Hilfe der "anodischen Oxidation" und der sog. Lift-Off-Technik bekannt, vgl. dort S. 203-207: "V.A. Browne and K.D. Perkins: A nonoverlapping Gate-Charge-Coupling Technology for Serial Memory and Signal Processing Applications".

Eine Technik zur Herstellung von integrierten Halbleiterschaltungen, in denen ausschließlich Elektroden aus Poly-Silizium, die sich nicht überlappen, verwendet werden, ist bisher nicht bekannt.

Der vorliegenden Erfindung liegt die Aufgabe zugrunde, ein Herstellungsverfahren zur Erzeugung von integrierten Halbleiterschaltungen, insbesondere CCD-Schaltungen, zu schaffen, durch das die bei bekannten Herstellungsverfahren unvermeidlichen Überlappungen der ersten mit der zweiten Elektrodenstruktur vermeidbar sind.

Die der Erfindung zugrundeliegende Aufgabe wird durch ein Verfahren zur Herstellung von integrierten Halbleiterschaltungen, insbesondere CCD-Schaltungen, gelöst, mit dem selbstjustierte, nichtüberlappende Poly-Silizium-Elektroden in zwei Ebenen erzeugbar sind.

Das erfindungsgemäße Verfahren ist dadurch gekennzeichnet, daß bei der Ätzung von Poly-Silizium-Elektroden einer ersten Art die maskierenden $SiO_2$- oder $Si_3N_4$-Strukturen an den Kanten zur Erzeugung von Überhängen der die Elektroden bedeckenden $SiO_2$- oder $Si_3N_4$- Schicht seitlich so weit unterätzt werden, daß der Abstand zwischen den Kanten der $SiO_2$- oder $Si_3N_4$-Maskenstrukturen und den Kanten der entsprechenden Poly-Si-1-Strukturen dem doppelten Betrag eines maximal auftretenden Kantenlagefehlers entspricht, der beim Überlagern der Poly-Si-1-Struktur durch eine zweite Poly-Silizium-Struktur entstehen kann, daß anschließend die nun bestehenden Kanten der Poly-Si-1-Strukturen zur Isolation mit einer SiO$_2$-Schicht belegt werden und daß daran anschließend gemäß einer aufgebrachten Maske die zweite Poly-Silizium-Schicht durch die an sich bekannte Gasphasenabscheidung (CVD) aufgetragen wird, wobei die geforderte nicht überlappende Gesamtstruktur entsteht.

Die Erfindung bietet den Vorteil, daß die störende unerwünschte Kapazitäten zwischen benachbarten Elektroden innerhalb einer betreffenden integrierten Schaltungsanordnung, beispielsweise einer CCD-Schaltung, hervorrufenden Überlappungen, die durch Fertigungstoleranzen im allgemeinen unvermeidbar sind, mit einfachen Mitteln ausgeschlossen werden können.

Weiterbildungen der Erfindung sind durch die in den Unteransprüchen angegebenen Merkmale gekennzeichnet.

Im folgenden wird die Erfindung an Hand mehrerer, den Stand der Technik und Ausführungsbeispiele für die Erfindung betreffender Figuren erläutert.

Figur 1 zeigt schematisch den Querschnitt durch einen Teilbereich einer nach einem herkömmlichen Verfahren hergestellten Schaltungsstruktur, bei der sich eine Poly-Si-1-Schicht und eine Poly-Si-2-Schicht über eine geringe Breite überlappen.

Figur 2 zeigt schematisch den Querschnitt durch einen Teilbereich einer nach einem herkömmlichen Verfahren hergestellten Schaltungsstruktur. Bei der die zweite Poly-Silizium-Schicht um den Betrag s eines Kantenlagefehlers in entgegengesetzter Richtung zu der betreffenden Elektrode der ersten Poly-Silizium-Schicht verschoben ist.

Figur 3 zeigt schematisch den Querschnitt durch einen
Teilbereich einer nach einem herkömmlichen Verfahren
hergestellten Schaltungsstruktur, bei der die zweite
Poly-Silizium-Schicht um den Betrag s eines Kantenlagefehlers in Richtung der betreffenden Elektrode der
ersten Poly-Silizium-Schicht verschoben ist.

Figur 4 zeigt schematisch den Querschnitt durch einen
Teilbereich einer nach dem erfindungsgemäßen Verfahren
hergestellten Schaltungsstruktur mit einer optimalen
Lage der zweiten Poly-Silizium-Schicht im Bezug auf die
jeweils erste Poly-Silizium-Schicht.

Figur 5 zeigt schematisch den Querschnitt durch einen
Teilbereich einer nach dem erfindungsgemäßen Verfahren
hergestellten Schaltungsstruktur, bei dem die zweite
Poly-Silizium-Schicht um den Betrag s des maximalen
Kantenlagefehlers in entgegengesetzter Richtung zu der
betreffenden Elektrode der ersten Poly-Silizium-Schicht
verschoben ist.

Figur 6 zeigt schematisch den Querschnitt durch einen
Teilbereich einer nach dem erfindungsgemäßen Verfahren
hergestellten Schaltungsstruktur, bei dem die Elektrode
der zweiten Poly-Silizium-Schicht um den Betrag s des
maximal vorkommenden Kantenlagefehlers in Richtung auf
die Elektrode der ersten Poly-Silizium-Schicht verschoben ist.

Figur 7 zeigt schematisch den Querschnitt durch einen peripheren Teilbereich der zuvor genannten Schaltungsanordnung, bei dem eine zweite Poly-Silizium-Schicht unter und über einem erfindungsgemäßen Überhang der $SiO_2$-Schicht aufgebracht ist.

Figur 8 zeigt schematisch den Querschnitt durch einen Teilbereich der Schaltungsanordnung gemäß Figur 7, bei dem nach Wegätzen einer bestimmten Schichtstärke bei der zweiten Poly-Silizium-Schicht ein Rest dieser zweiten Poly-Silizium-Schicht in der Höhlung unter dem Überhang der $SiO_2$-Schicht verblieben ist.

Figur 9 zeigt schematisch den Querschnitt durch einen Teilbereich der Peripherie der betreffenden Schaltungsstruktur, bei dem vor dem Aufbringen der zweiten Poly-Silizium-Schicht der Überhang der $SiO_2$-Schicht durch einen besonderen Ätzvorgang beseitigt worden ist, und bei dem die zweite Poly-Silizium-Schicht in einem vorläufigen Verfahrensschritt aufgebracht ist.

Figur 10 zeigt schematisch den Querschnitt des in Figur 9 gezeigten Teilbereiches der betreffenden Schaltungsstruktur, bei dem die zweite Poly-Silizium-Schicht in den Bereichen der über der ersten Poly-Silizium-Schicht liegenden $SiO_2$-Schicht und der Feldoxid-Schicht 3 weggeätzt ist.

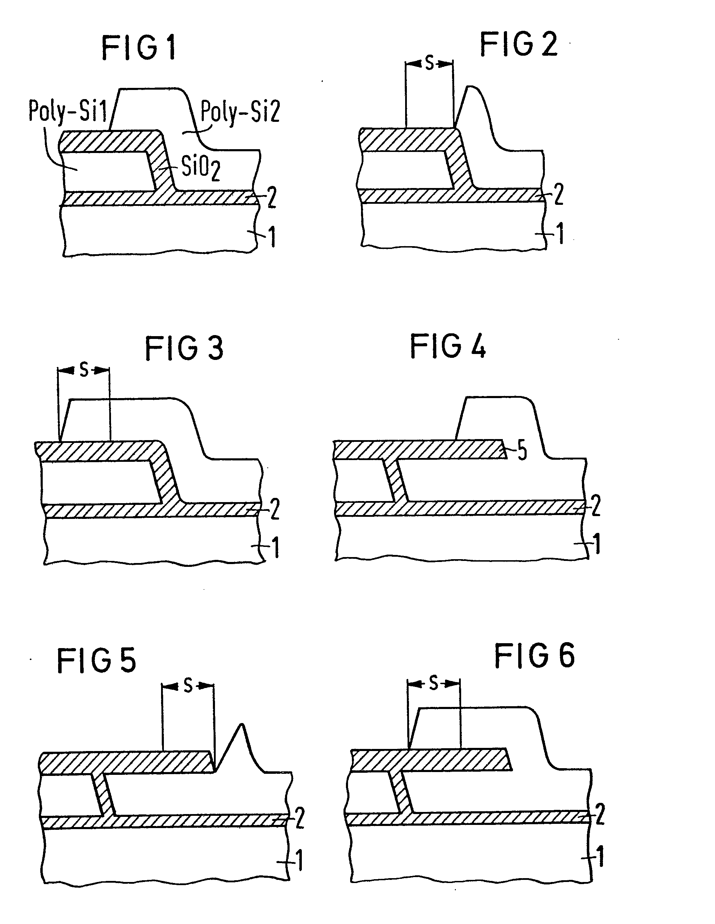

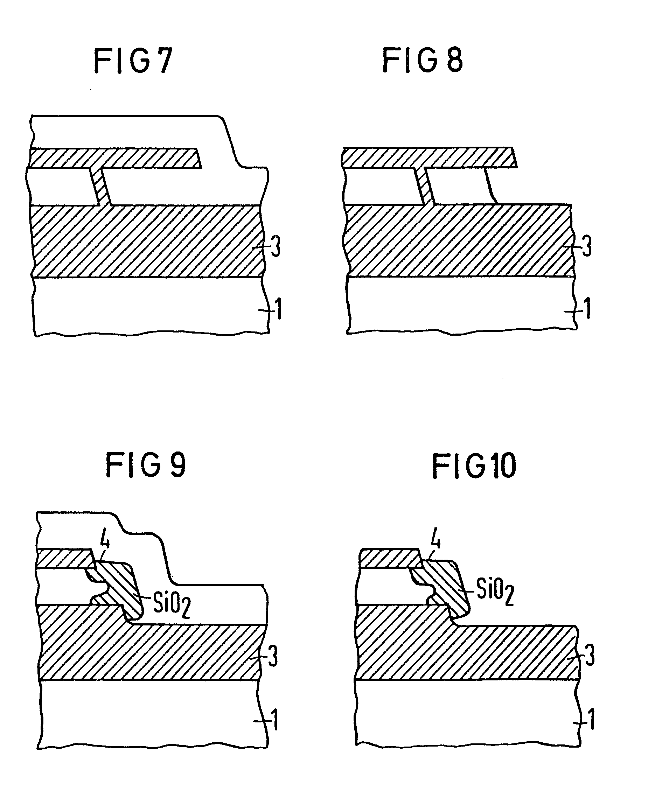

Wie bereits erwähnt, zeigen die Figuren 4, 5, 6 schematisch Querschnitte durch gemäß der vorliegenden Erfindung erzeugbare Schaltungsstrukturen. Bei der Ätzung der Poly-Si-1-Elektroden werden die maskierenden $SiO_2$- oder $Si_3N_4$-Strukturen, deren Dicke ca. 0,1 Mikrometer beträgt, an den Kanten seitlich so weit unterätzt, daß der Abstand zwischen den Kanten der $SiO_2$-bzw. $Si_3N_4$- Maskenstrukturen und den Kanten der entsprechenden geätzten Poly-Si-1-Strukturen dem doppelten Kantenlagefehler $\pm$ s entspricht, der beim Überlagern der beiden Poly-Si-Strukturebenen zwischen Poly-Si-1- und Poly-Si-2-Strukturkanten entstehen kann.

Anschließend an diese Unterätzung wird eine $SiO_2$-Schicht zur Isolation der betreffenden Poly-Si-1-Elektroden gegenüber benachbarten Elektroden aufgebracht. Dies geschieht vorteilhafterweise gemäß einer Weiterbildung der Erfindung durch die sog. thermische Oxidation. Die thermische Oxidation hat den Vorteil, daß auch die $SiO_2$-Schicht zwischen Poly-Si-1 und Poly-Si-2-Elektroden etwas weiter wächst, so daß die Koppelkapazität weiter verringert werden kann.

Gemäß einer anderen Weiterbildung der Erfindung ist vorgesehen, daß in den Bereichen, vorzugsweise den peripheren Bereichen, in denen die erzeugten Elektroden kreuzende Leiterbahnen vorgesehen sind, die Überhänge 5 nach dem Ätzen der ersten Poly-Silizium-Schicht Poly-Si-1 drch an sich bekannte Verfahrensschritte so weit weggeätzt werden, daß alle jeweils entstandenen Kontaktlochkanten 4 hinter den jeweils betreffenden Kanten der Poly-Si-1-Elektroden, nämlich auf den Flächen der betreffenden Elektroden, positioniert sind, so daß nach einer thermischen Oxidation und nach dem Wegätzen der in einem weiteren Verfahrensschritt aufgetragenen zweiten Poly-Silizium-Schicht Poly-Si-2 in

0026386

den genannten Bereichen keine Kurzschlüsse verursachende Reste der zweiten Poly-Silizium-Schicht
Poly-Si-2 verbleiben.

3 Patentansprüche
10 Figuren

<u>Patentansprüche</u>

1. Verfahren zur Herstellung von integrierten Halbleiterschaltungen, insbesondere CCD-Schaltungen, mit
selbst-justierten, nichtüberlappenden Poly-Silizium-
Elektroden, dadurch g e k e n n z e i c h n e t ,
daß bei der Ätzung von Poly-Silizium-Elektroden einer
ersten Art (Poly-Si-1) die maskierenden $SiO_2$- oder
$Si_3N_4$- Strukturen an den Kanten zur Erzeugung von Überhängen (5) der die Elektroden bedeckenden $SiO_2$- oder
$Si_3N_4$- Schicht seitlich soweit unterätzt werden, daß
der Abstand zwischen den Kanten der $SiO_2$- oder $Si_3N_4$-
Maskenstrukturen und den Kanten der entsprechenden geätzten Poly-Si-1-Strukturen dem doppelten Betrag eines
maximal auftretenden Kantenlagefehlers ($\pm$ s) entspricht,
der beim Überlagern der Poly-Si-1-Struktur durch eine
zweite Poly-Silizium-Struktur (Poly-Si-2) entstehen
kann, daß anschlie ßend die nun bestehenden Kanten der
Poly-Si-1-Strukturen zur Isolation mit einer $SiO_2$-
Schicht belegt werden und daß daran anschließend gemäß einer aufgebrachten Maske die zweite Poly-Silizium-
Schicht (Poly-Si-2) durch die an sich bekannte Gasphasenabscheidung CVD aufgetragen wird, wobei die geforderte nicht überlappende Gesamtstruktur entsteht.

2. Verfahren nach Anspruch 1, dadurch g e k e n n -
z e i c h n e t , daß in den Bereichen, vorzugsweise
den peripheren Bereichen, in den die erzeugten Elektroden kreuzende Leiterbahn vorgesehen sind, die Überhänge (5) vor dem Abscheiden der zweiten Poly-Silizium-
Schicht (Poly-Si-2) durch an sich bekannte Verfahrensschritte so weit weggeätzt werden, daß alle jeweils
entstandenen Kontaktlochkanten (4) hinter den jeweils
betreffenden Kanten der zugeordneten Poly-Si-1-Elektroden, nämlich auf den Flächen der betreffenden Elektroden, positioniert sind, so daß nach dem Wegätzen der in einem weiteren Verfahrensschritt aufgetragenen zweiten Poly-Silizium-Schicht (Poly-Si-2) in den genannten Bereichen keine Kurzschlüsse verursachende Reste der zweiten Poly-Silizium-Schicht (Poly-Si-2) verbleiben.

3. Verfahren nach Anspruch 1, dadurch g e k e n n - z e i c h n e t , daß das Aufbringen der $SiO_2$-Schicht durch thermische Oxidation vorgenommen wird.

## FIG 1

Poly-Si1    Poly-Si2

SiO₂

2

1

## FIG 2

s

2

1

## FIG 3

s

2

1

## FIG 4

5

2

1

## FIG 5

s

2

1

## FIG 6

s

2

1

FIG 7

FIG 8

FIG 9

FIG 10

SiO$_2$

SiO$_2$